# EUROPÄISCHE PATENTSCHRIFT

(11) **EP 2 662 695 B1**
(45) Veröffentlichungstag und Bekanntmachung des Hinweises auf die Patenterteilung: **08.07.2015**
(21) Anmeldenummer: 12003726.2
(22) Anmeldetag: 10.05.2012
(51) Int. Cl.: G01R 27/20, G01R 31/327

(54) **Messung eines Widerstandes eines Schaltkontakts eines elektrischen Leistungsschalters**
Measurement of a resistance of a switch contact of an electrical circuit breaker
Mesure d'une résistance d'un contacteur de commutation d'un disjoncteur électrique

(43) Veröffentlichungstag der Anmeldung: 13.11.2013
(73) Patentinhaber: Omicron electronics GmbH, 6833 Klaus (AT)
(72) Erfinder: Klapper, Ulrich, 6830 Rankweil (AT)
(74) Vertreter: Banzer, Hans-Jörg

(56) Entgegenhaltungen:
- US-A- 4 104 578
- US-B1- 6 815 955
- ZORAN STANISIC: "Method for static and dynamic resistance measurements of HV circuit breaker", INNOVATIVE SMART GRID TECHNOLOGIES (ISGT EUROPE), 2011 2ND IEEE PES INTERNATIONAL CONFERENCE AND EXHIBITION ON, IEEE, 5. Dezember 2011 (2011-12-05), Seiten 1-5, XP032136558, DOI: 10.1109/ISGTEUROPE.2011.6162618 ISBN: 978-1-4577-1422-1

## Beschreibung

Die vorliegende Erfindung betrifft eine Messvorrichtung und ein Verfahren zur Messung eines Widerstandes eines Schaltkontakts eines elektrischen Leistungsschalters oder eines elektrischen Hochspannungsschalters.

Leistungsschalter, welche auch als Hochspannungsschalter oder Circuit Breaker bezeichnet werden, werden in der Energietechnik verwendet, um elektrische Verbindungen unter Last herzustellen oder zu trennen. Die Nennspannungen der Leistungsschalter können im Bereich von wenigen Volt bis zu einigen hundert Kilovolt liegen. Die geschalteten Lastströme können bei einem Kurzschluss mehrere zehn Kiloampere betragen. Für einen zuverlässigen Betrieb des Leistungsschalters wird daher beispielsweise im Rahmen von Revisionen, der Übergangswiderstand eines Schaltkontakts des elektrischen Leistungsschalters überprüft. Ein hoher Verschleiß an dem Schaltkontakt des Leistungsschalters, beispielsweise ein Abbrand der Lichtbogenkontakte kann beim Schalten unter Last und insbesondere beim Trennen eines Kurzschlussstroms auftreten.

In diesem Zusammenhang offenbart die Veröffentlichung von Zoran Stanisic "Method for static and dynamic resistance measurements of HV circuit breaker"Innovative Smart Grid Technologies (ISGT Europe), 2011 2nd IEEE PES International Conference and Exhibition on, IEEE, 5. Dezember 2011, Seiten 1-5 ein Verfahren für statistische und dynamische Widerstandsmessungen eines Hochspannungsschalters. Bei dem vorgeschlagenen Verfahren werden Batterien durch Ultra-Kondensatoren und eine Konstantstromladevorrichtung ersetzt, was zu einer leistungsfähigen Stromquelle mit wenigen hundert Gramm führt, welche in der Lage ist, einige hundert Ampere für die Leistungsschalterkontakte zu erzeugen. Ein Messen eines Spannungsabfalls über dem Leistungsschalter und des Stroms dadurch überwacht kontinuierlich ein Entladen der Ultra-Kondensatoren, was einen sehr genauen Widerstandswert des gemessenen Objekts ergibt.

Aufgabe der vorliegenden Erfindung ist es daher, einen Zustand, insbesondere einen Verschleißzustand des Schaltkontakts eines elektrischen Leistungsschalters zu bestimmen sowie den mechanischen Zustand des Antriebs und der Kontakte zu überprüfen.

Diese Aufgabe wird gemäß der vorliegenden Erfindung durch eine Messvorrichtung zur Messung eines Widerstandes eines Schaltkontakts eines elektrischen Leistungsschalters nach Anspruch 1 und ein Verfahren zur Messung eines Widerstandes eines Schaltkontakts eines elektrischen Leistungsschalters nach Anspruch 9 gelöst. Die abhängigen Ansprüche definieren bevorzugte und vorteilhafte Ausführungsformen der Erfindung.

Gemäß der vorliegenden Erfindung wird eine Messvorrichtung zur Messung eines Widerstandes eines Schaltkontakts eines elektrischen Leistungsschalters bereitgestellt. Die Messvorrichtung umfasst eine Hochstromerzeugungseinheit und eine Messeinheit. Die Hochstromerzeugungseinheit dient zur Erzeugung eines Messstroms für die Widerstandsmessung und ist zur Einspeisung des Messstroms in den Leistungsschalter mit dem Leistungsschalter koppelbar. Die Messeinheit ist mit dem Leistungsschalter koppelbar und ausgestaltet, ein Messsignal an dem Leistungsschalter zu erfassen. Das Messsignal kann beispielsweise eine Spannung über dem Schaltkontakt des Leistungsschalters umfassen. Die Messvorrichtung ist in der Lage, das Messsignal während des Öffnens oder während des Schließens des Schaltkontakts zu erfassen und einen zeitlichen Widerstandsverlauf des Schaltkontakts beim Öffnen oder Schließen in Abhängigkeit von dem Messstrom und dem Messsignal zu bestimmen. Durch die Bestimmung des zeitlichen Widerstandsverlaufs des Schaltkontakts kann nicht nur der Übergangswiderstand des Schaltkontakts im geschlossenen Zustand bestimmt werden, sondern auch ein zeitliches Verhalten des Widerstands des Schaltkontakts bestimmt werden, während Kontakte des Schaltkontakts beim Schließen des Leistungsschalters in Berührung gebracht werden oder beim Öffnen des Leistungsschalters voneinander gelöst werden. Anhand des zeitlichen Widerstandsverlaufs kann beispielsweise ein Verschleißzustand des Schaltkontakts bestimmt werden. Erfindungsgemäß umfasst die Messvorrichtung ein Gehäuse in Form einer tragbaren Einheit. In dem Gehäuse sind zumindest die Hochstromerzeugungseinheit und die Messeinheit untergebracht. Dadurch kann die Messvorrichtung in unmittelbarer Nähe des Leistungsschalters angeordnet werden, sodass Leistungsverluste der Hochstromerzeugungseinheit über lange Zuleitungskabel minimiert werden können und darüber hinaus Messsignale störungsfrei oder störungsarm erfasst werden, da auch die Messsignale nicht über lange Zuleitungen übertragen werden müssen. Die Messvorrichtung kann insbesondere derart ausgebildet sein, dass das Gehäuse beispielsweise am Gehäuse des Schaltkontakts, wie z.B. einem Keramikgehäuse, des Schaltkontakts angeordnet wird, sodass Zuleitungen zu den Anschlüssen des Leistungsschalters sehr kurz ausgeführt werden können, beispielsweise mit einer Länge von 1-2 m für einen Hochspannungsschalter und deutlich kürzer als 1 m für einen Mittelspannungsschalter. Vorzugsweise sind an der Messvorrichtung keine Bedienelemente.

Die Messeinheit ist ausgestaltet, den Widerstandsverlauf des Schaltkontakts in Abhängigkeit von dem Messstrom und dem Messsignal als eine Folge von digitalen Widerstandswerten zu bestimmen. Die Folge von digitalen Widerstandswerten wird über einen Energieversorgungsanschluss, welcher zur Versorgung der Messvorrichtung mit elektrischer Energie dient, ausgegeben. Der Energieversorgungsanschluss kann beispielsweise ein sogenannter Power over Ethernet Anschluss oder ein sogenannter Power Line Communication Anschluss sein. Bei dem Power over Ethernet Anschluss oder dem Power Line Communication Anschluss werden hingegen die elektrische Energie zur Versorgung der Messvorrichtung als auch die Folge von digitalen Widerstandswerten über gemeinsame Leiter übertragen. Die Folge von digitalen Widerstandswerten kann beispielsweise an eine Bodenstation übertragen werden, welche beispielsweise eine elektronische Steuerung oder einen Computer umfasst und zur Speicherung und Auswertung der Folge von digitalen Widerstandswerten geeignet ist. Somit kann die Messvorrichtung zur Messung eines Widerstandes eines Schaltkontaktes von beispielsweise einem Leistungsschalter an einer Hochspannungsleitung in unmittelbarer Nähe zu dem Leistungsschalter in einer Höhe von beispielsweise 6 m, in welcher sich der Leistungsschalter befindet, angeordnet werden und über entsprechend kurze Verbindungen mit dem Leistungsschalter gekoppelt werden. Die Übertragung des zeitlichen Widerstandsverlaufs, beispielsweise als eine Folge von digitalen Widerstandswerten, zu der Bodenstation kann über ein entsprechend längeres Kabel erfolgen, sodass die Messwerte von der Messvorrichtung mit großer Genauigkeit erfasst werden können und ohne Störungen oder Fehler digital an die Bodenstation übertragen werden können.

Gemäß einer weiteren Ausführungsform umfasst die Messvorrichtung einen kapazitiven Energiespeicher, beispielsweise einen Kondensator, welcher mit der Hochstromerzeugungseinheit gekoppelt ist. Die Hochstromerzeugungseinheit ist in der Lage, für einen bestimmten Zeitraum, insbesondere für einen bestimmten Messzeitraum, einen Messstrom aus sowohl elektrischer Energie von dem kapazitiven Energiespeicher als auch aus elektrischer Energie von dem Energieversorgungsanschluss der Messvorrichtung zu erzeugen. Der so erzeugte Messstrom weist eine elektrische Leistung auf, welche höher ist als die von der Messvorrichtung während des Zeitraums über den Energieversorgungsanschluss aufgenommene Leistung. Der kapazitive Energiespeicher dient somit zur Pufferung von elektrischer Energie, um eine Strom- oder Energieaufnahme der Messvorrichtung während der Widerstandsmessung gering zu halten und gleichzeitig einen Messstrom mit einer erheblich größeren Leistung für die Widerstandsmessung bereitstellen zu können. Die Hochstromerzeugungseinheit kann beispielsweise einen Messstrom von einigen 10 Ampere erzeugen, beispielsweise einen Messstrom von mindestens 100 Ampere.

Gemäß einer Ausführungsform umfasst die Messvorrichtung ferner eine Steuereinheit in einem separaten Gehäuse. Die Steuereinheit ist ausgestaltet, den Leistungsschalter zum Öffnen oder Schließen des Schaltkontakts anzusteuern.

Gemäß einer weiteren Ausführungsform ist die Steuereinheit in der Lage, digitale Steuersignale zum Öffnen oder Schließen des Schaltkontakts über ein Computernetzwerk auszugeben. Die digitalen Steuersignale können beispielsweise Signale gemäß der Norm IEC 61850 umfassen. Leistungsschalter, welche in der Lage sind ihre Schaltkontakte aufgrund von Kommandos gemäß der Norm IEC 61850, sogenannte Goose-Nachrichten, zu öffnen oder zu schließen, können demzufolge von der Messvorrichtung angesteuert werden, um einen zeitlichen Widerstandsverlauf des Schaltkontakts beim Öffnen oder Schließen zu bestimmen oder aufzuzeichnen. Dadurch kann der Messvorgang automatisiert durchgeführt werden.

Erfindungsgemäß wird weiterhin ein Verfahren zur Messung eines Widerstandes eines Schaltkontakts eines elektrischen Leistungsschalters bereitgestellt. Bei dem Verfahren wird ein Messstrom für die Widerstandsmessung erzeugt und der Messstrom in den Leistungsschalter eingespeist. Der Leistungsschalter wird zum Öffnen oder Schließen des Schaltkontakts angesteuert und während des Öffnens oder Schließens des Schaltkontakts wird ein Messsignal an dem Leitungsschalter erfasst. In Abhängigkeit von dem Messstrom und dem Messsignal wird ein zeitlicher Widerstandsverlauf des Schaltkontakts beim Öffnen oder Schließen bestimmt. Das Verfahren kann mit der zuvor beschriebenen Messvorrichtung durchgeführt werden. Die Messvorrichtung kann insbesondere in unmittelbarer Nähe des Leistungsschalters angeordnet werden. Anders ausgedrückt wird die Messvorrichtung bei beispielsweise einem Hochspannungsschalter näherungsweise in gleicher Höhe angeordnet, in welcher sich die Schaltkontakte befinden. Dadurch können die Leitungen zur Einspeisung des Messstroms in den Leistungsschalter und zur Erfassung des Messsignals entsprechend kurz ausgestaltet werden, sodass Störungen von benachbarten gleichzeitig stattfindenden Messungen oder sonstige elektromagnetische Störungen von beispielsweise Schalteinrichtungen oder Energieanlagen möglichst wenig eingekoppelt werden. Dadurch kann der Zustand und die Funktionsfähigkeit des Leistungsschalters insbesondere nach einer Erstinstallation oder Wartung oder Revision zuverlässig und mit hoher Genauigkeit bestimmt werden.

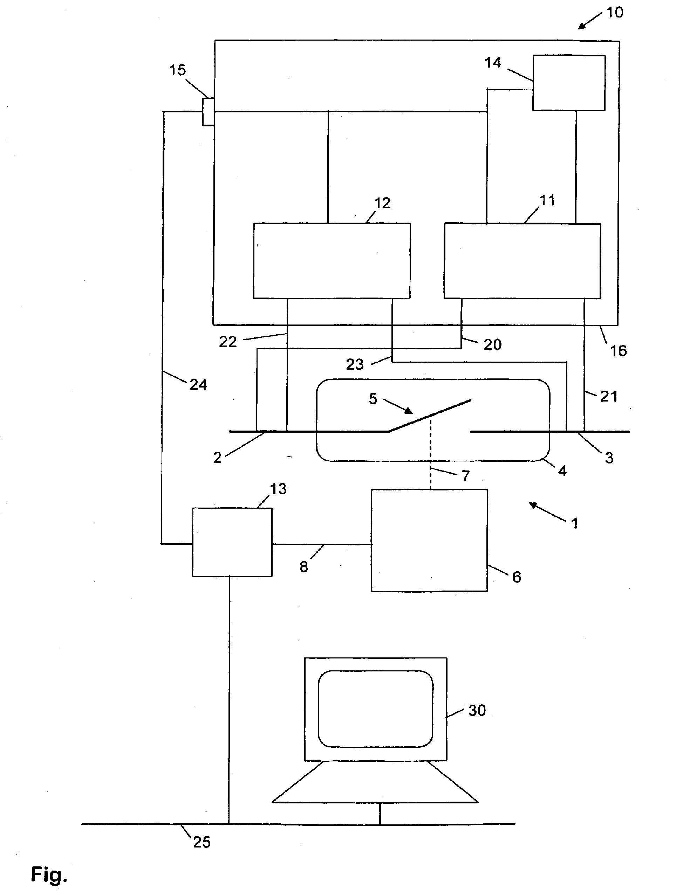

Die vorliegende Erfindung wird nachfolgend unter Bezugnahme auf die Zeichnung anhand bevorzugter Ausführungsformen erläutert werden. Die einzige Figur zeigt schematisch eine Messvorrichtung gemäß einer Ausführungsform der vorliegenden Erfindung, welche mit einem Leistungsschalter und einer Bodenstation gekoppelt ist.

Die Figur zeigt einen Leistungsschalter 1, welcher mit Leitungen 2 und 3 gekoppelt ist, um die Leitungen 2 und 3 wahlweise elektrisch miteinander zu koppeln oder eine bestehende elektrische Verbindung zwischen den Leitungen 2 und 3 zu trennen. Der Leistungsschalter 1 umfasst ein Gehäuse 4, in welchem ein Schaltkontakt 5 angeordnet ist, welcher den eigentlichen Schaltvorgang durchführt. Der Leistungsschalter 1 umfasst weiterhin einen Steuerantrieb 6, welcher den Schaltkontakt 5 über eine mechanische Kopplung 7 betätigt. Der Steuerantrieb 6 kann beispielsweise einen sogenannten Federspeicherantrieb umfassen, welcher Federn als Energiespeicher zum Bereitstellen der mechanischen Energie zum Öffnen und Schließen des Schaltkontakts 5 umfasst. Der Steuerantrieb 6 kann weiterhin einen elektrischen Antrieb, beispielsweise einen Elektromotor umfassen, welcher die Federn spannt. Weiterhin kann der Steuerantrieb 6 Auslösespulen umfassen, welche aufgrund einer elektrischen Ansteuerung die in den Spulen gespeicherte mechanische Energie zum Öffnen oder Schließen des Schaltkontakts 5 freigeben. Der Steuerantrieb 6 kann zur Versorgung des Steuerantriebs 6 mit elektrischer Energie einen entsprechenden Stromanschluss aufweisen. Die Steuerung der Auslösespulen kann beispielsweise über die in der Figur gezeigt Verbindung 8 erfolgen. Alternativ können Kommandos zum Öffnen oder Schließen des Schaltkontakts 5 auch über ein Bussystem gemäß beispielsweise der Norm IEC 61850 an den Steuerantrieb 6 übertragen werden.

In der Figur ist weiterhin eine Steuereinheit 13 gezeigt welche Kommandos an den Steuerantrieb 6 über die Leitung 8 zum Öffnen und Schließen des Schaltkontakts 5 absetzen kann.

In der Figur ist weiterhin eine Messvorrichtung 10 gezeigt, welche zur Messung eines Widerstandes des Schaltkontakts 5 des elektrischen Leistungsschalters 1 ausgestaltet ist. Die Messvorrichtung 10 umfasst eine Hochstromerzeugungseinheit 11, eine Messeinheit 12 und ein Gehäuse 16. Die Hochstromerzeugungseinheit 11 kann einen Messstrom von mehreren 100 Ampere, beispielsweise 200 Ampere erzeugen, welcher über Leitungen 20, 21 in den Leistungsschalter 1 eingespeist wird. Die Messeinheit 12 ist über Leitungen 22 und 23 mit dem Leistungsschalter 1 gekoppelt und in der Lage, ein Messsignal zu erfassen, beispielsweise einen Spannungsabfall, welcher aufgrund des Messstroms von der Hochstromerzeugungseinheit 11 an dem Leistungsschalter, insbesondere über dem Schaltkontakt 5, auftritt. Die Messvorrichtung 10 umfasst weiterhin einen Energieversorgungsanschluss 15, welcher über eine Leitung 24 mit beispielsweise einem Energieversorgungssystem gekoppelt werden kann. Über den Energieversorgungsanschluss 15 kann die Messvorrichtung 10 beispielsweise mit einer üblichen Netzspannung von 230 Volt versorgt werden. Die Hochstromerzeugungseinheit 11 erzeugt aus der über den Energieversorgungsanschluss 15 bereitgestellten Energie den Messstrom für die Widerstandsmessung. Um kurzzeitig einen Messstrom zu erzeugen, welcher eine größere Leistung aufweist, als über den Energieversorgungsanschluss 15 bereitgestellt werden kann, kann die Messvorrichtung 10 einen kapazitiven Energiespeicher 14 umfassen, welcher vor der Widerstandsmessung mit Energie von dem Energieversorgungssystem aufgeladen wird und während der Widerstandsmessung zusätzliche Energie für die Hochstromerzeugungseinheit 11 bereitstellt.

Die Steuereinheit 13 ist mit der Hochstromerzeugungseinheit 11 und der Messeinheit 12 sowie über die Verbindung 8 mit dem Steuerantrieb 6 des Leistungsschalters 1 gekoppelt. Über die Verbindung 8 kann die Steuereinheit 13 den Leistungsschalter 1 zum Öffnen oder Schließen des Schaltkontakts 5 ansteuern. Während des Öffnens oder Schließens des Schaltkontakts 5 erfasst die Messeinheit 12 ein Messsignal und bestimmt in Abhängigkeit von dem von der Hochstromerzeugungseinheit 11 erzeugten Messstrom und dem Messsignal einen zeitlichen Widerstandsverlauf des Schaltkontakts 5 beim Öffnen bzw. Schließen. Um eine hohe Messgenauigkeit des zeitlichen Widerstandsverlaufs zu erzielen, wird die Messvorrichtung 10 in unmittelbarer Nähe zu dem Leistungsschalter 1 angeordnet. Im Falle eines Leistungsschalters für eine Hochspannungsleitung ist der Schaltkontakt 5 im Allgemeinen in mehreren Metern Höhe über dem Boden, beispielsweise in 6 m Höhe, angeordnet. Dementsprechend wird die Messvorrichtung 10 in näherungsweise gleicher Höhe und in unmittelbarer Nähe zu dem Leistungsschalter 1 angeordnet. Beispielsweise kann die Messvorrichtung an dem Gehäuse 4 des Leistungsschalters 1 oder an den Hochspannungsleitungen 2 oder 3 befestigt werden. Dadurch sind nur sehr kurze Verbindungen 20-23 erforderlich, sodass Störungen von anderen Messungen an anderen Leistungsschaltern oder sonstige elektromagnetische Störungen nur einen geringen Einfluss auf das von der Messeinheit 12 erfasste Messsignal haben. Darüber hinaus treten aufgrund der kurzen Verbindungslängen nur geringe Energieverluste in den Verbindungen 20, 21 aufgrund des Messstroms von der Hochstromerzeugungseinheit 11 auf. Die Messvorrichtung 10 kann das erfasste Messsignal oder den daraus bestimmten zeitlichen Widerstandsverlauf in eine digitale Form umwandeln und diese zu einer Boden- oder Basisstation 30, beispielsweise einem Messplatz oder einem PC, übertragen. Die Übertragung der digitalisierten Informationen kann beispielsweise zu der Steuereinheit 13 über eine Leitung erfolgen, welche integriert mit der Verbindung 24 ausgebildet ist, und von der Steuereinheit 13 weiter über beispielsweise ein Netzwerk 25 zu der Bodenstation 30. Dazu kann die Verbindung 24 beispielsweise mehrere elektrische Leiter umfassen, welche einerseits für die Übertragung elektrischer Energie zu der Messvorrichtung und andererseits für die Übertragung der digitalisierten Informationen von der Messvorrichtung zu der Steuereinheit 13 dienen. Alternativ kann die Verbindung 24 auch eine sogenannte Power over Ethernet oder eine sogenannte Power Line Communication Verbindung umfassen, bei welcher sowohl Energie als auch digitalisierte Informationen über gemeinsame Leiter übertragen werden.

Durch die Messung des zeitlichen Widerstandsverlaufs des Schaltkontakts 5 beim Öffnen oder Schließen kann der Zustand des Schaltkontakts 5 aufgrund des Verlaufs des Widerstandes über der Zeit oder über dem Schaltweg beispielsweise nach einer Installation des Leistungsschalters oder nach einer Revision des Leistungsschalters 1 überprüft und beurteilt werden. Durch die unmittelbare Anordnung der Messvorrichtung 10 in der Nähe des Leistungsschalters 1 kann die Messgenauigkeit erhöht werden und es wird weniger Energie für die Messung des Widerstandes benötigt. Indem der bestimmte zeitliche Widerstandsverlauf über die Verbindung 24 zu der Bodenstation 30 übertragen wird, kann die Verkabelung der Messanordnung vereinfacht werden.

Die Messvorrichtung 10 kann weitere Komponenten umfassen, welche in der Figur nicht gezeigt sind. Weiterhin kann der Steuerantrieb 6 eine Energieversorgungseinheit umfassen, welche beispielsweise Energie für den Elektromotor des Steuerantrieb 6 zum Spannen der Federn bereitstellt und Steuerspannungen zum Ansteuern der Auslösespulen des Steuerantriebs 6 erzeugt.

## Patentansprüche

1. Messvorrichtung zur Messung eines Widerstandes eines Schaltkontakts (5) eines elektrischen Leistungsschalters (1), umfassend:
- eine Hochstromerzeugungseinheit (11), welche zur Erzeugung eines Messstrom für die Widerstandsmessung ausgestaltet ist und zur Einspeisung des Messstroms in den Leistungsschalter (1) mit dem Leistungsschalter (1) koppelbar ist, und
- eine Messeinheit (12), welche mit dem Leistungsschalter (1) koppelbar ist und ausgestaltet ist, ein Messsignal an dem Leistungsschalter (1) während des Öffnens oder Schließens des Schaltkontakts (5) zu erfassen, und einen zeitlichen Widerstandsverlauf des Schaltkontakts (5) beim Öffnen oder Schließen in Abhängigkeit von dem Messstrom und dem Messsignal zu bestimmen, wobei die Messvorrichtung (10) ein Gehäuse (16) in Form einer am Schaltkontakt (5) montierbaren Einheit umfasst, in welchem zumindest die Hochstromerzeugungseinheit (11) und die Messeinheit (12) untergebracht sind, wobei die Messeinheit (12) ferner ausgestaltet ist, den Widerstandsverlauf des Schaltkontakts (5) als eine Folge von digitalen Widerstandswerten zu bestimmen **gekennzeichnet durch** einen Energieversorgungsanschluss (15) zur Versorgung der Messvorrichtung (10) mit elektrischer Energie, wobei die Messeinheit (12) ausgestaltet ist, die Folge von digitalen Widerstandswerten über den Energieversorgungsanschluss (15) auszugeben.

2. Messvorrichtung nach Anspruch 1, ferner umfassend eine Steuereinheit (13) in einem separaten Gehäuse, welche ausgestaltet ist, den Leistungsschalter (1) zum Öffnen oder Schließen des Schaltkontakts (5) anzusteuern.

3. Messvorrichtung nach Anspruch 1 oder 2, wobei die Versorgung der Messvorrichtung (10) und die Übertragung der Folge von digitalen Widerstandswerten von Messvorrichtung (10) über dieselben elektrischen Leiter erfolgt.

4. Messvorrichtung nach Anspruch 3, wobei der Energieversorgungsanschluss (15) einen Power over Ethernet Anschluss oder einen Power Line Communication Anschluss umfasst.

5. Messvorrichtung nach einem der vorhergehenden Ansprüche, ferner umfassend einen kapazitiven Energiespeicher (14), welcher mit der Hochstromerzeugungseinheit (11) gekoppelt ist, wobei die Hochstromerzeugungseinheit (11) ausgestaltet ist, für einen bestimmten Zeitraum einen Messstrom getrieben von elektrischer Energie von dem kapazitiven Energiespeicher (14) und elektrischer Energie von einem Energieversorgungsanschluss (15) der Messvorrichtung (10) zu erzeugen, wobei der Messstrom mit einer größeren elektrischen Leistung getrieben wird als von der Messvorrichtung (10) während des Zeitraums über den Energieversorgungsanschluss (15) aufgenommen wird.

6. Messvorrichtung nach einem der vorhergehenden Ansprüche, wobei die Hochstromerzeugungseinheit (11) zur Erzeugung eines Messstroms von mindestens 100A ausgestaltet ist.

7. Messvorrichtung nach einem der vorhergehenden Ansprüche, wobei das Messsignal eine Spannung über dem Schaltkontakt (5) des Leistungsschalters (1) umfasst.

8. Messvorrichtung nach einem der vorhergehenden Ansprüche, wobei die Steuereinheit (13) ausgestaltet ist, digitale Steuersignale über ein Netzwerk zum Öffnen oder Schließen des Schaltkontakts (5) auszugeben.

9. Verfahren zur Messung eines Widerstandes eines Schaltkontakts (5) eines elektrischen Leistungsschalters (1), umfassend:
- Erzeugen eines Messstroms für die Widerstandsmessung mit einer Hochstromerzeugungseinheit (11),
- Einspeisen des Messstroms in den Leistungsschalter (1),
- Ansteuern des Leistungsschalters (1) zum Öffnen oder Schließen des Schaltkontakts (5), und
- Erfassen eines Messsignals an dem Leistungsschalter (1) während des Öffnens oder Schließens des Schaltkontakts (5) mit einer Messeinheit (12), und
- Bestimmen eines zeitlichen Widerstandsverlaufs des Schaltkontakts (5) beim Öffnen oder Schließen in Abhängigkeit von dem Messstrom und dem Messsignal als eine Folge von digitalen Widerstandswerten,
wobei das Verfahren mit einer Messvorrichtung durchgeführt wird, wobei die Messvorrichtung (10) ein Gehäuse (16) in Form einer am Schaltkontakt (5) montierbaren Einheit umfasst, in welchem zumindest die Hochstromerzeugungseinheit (11) und die Messeinheit (12) untergebracht sind, und wobei die Messvorrichtung über einen Energieversorgungsanschluss (15) mit elektrischer Energie versorgt wird,
**gekennzeichnet durch**
- Ausgeben der Folge von digitalen Widerstandswerten über den Energieversorgungsanschluss (15).

10. Verfahren nach Anspruch 9, wobei das verfahren mit der Messvorrichtung (10) nach einem der Ansprüche 1-8 durchgeführt wird.

11. Verfahren nach Anspruch 10, wobei die Messvorrichtung (10) in unmittelbarer Nähe des Leistungsschalters (1) angeordnet wird.

12. Verfahren nach Anspruch 10 oder 11, wobei die Messvorrichtung (10) in unmittelbarer Nähe eines Gehäuses (4) des Schaltkontakts (5) angeordnet wird.

## Claims

1. Measuring apparatus for measuring a resistance of a switching contact (5) of an electrical circuit breaker (1), comprising:
- a high-current generating unit (11), which is designed to generate a measurement current for the resistance measurement, and which can be coupled to the circuit breaker (1) for feeding the measurement current into the circuit breaker (1), and
- a measuring unit (12), which can be coupled to the circuit breaker (1), and which is designed to detect a measurement signal at the circuit breaker (1) during the opening or closing of the switching contact (5), and to determine a time-based resistance course of the switching contact (5) during opening or closing in dependence on the measurement current and the measurement signal, the measuring apparatus (10) comprising a housing (16) in the form of a unit that can be mounted on the switching contact (5), in which housing (16) at least the high-current generating unit (11) and the measuring unit (12) are accommodated, the measuring unit (12) further being designed to determine the resistance course of the switching contact (5) as a sequence of digital resistance values,
**characterized by**
an energy supply connection (15) for supplying the measuring apparatus (10) with electrical energy, the measuring unit (12) being designed to output the sequence of digital resistance values via the energy supply connection (15).

2. Measuring apparatus according to claim 1, further comprising a control unit (13) in a separate housing, which control unit is designed to control the circuit breaker (1) to open or close the switching contact (5).

3. Measuring apparatus according to claim 1 or claim 2, the supplying of the measuring apparatus (10) and the transmission of the sequence of digital resistance values from the measuring apparatus (10) being effected via the same electrical conductors.

4. Measuring apparatus according to claim 3, the energy supply connection (15) comprising a Power over Ethernet connection or a Power Line communication connection.

5. Measuring apparatus according to any one of the preceding claims, further comprising a capacitive energy storage device (14), which is coupled to the high-current generating unit (11), the high-current generating unit (11) being designed to generate a measurement current for a defined period, driven by electrical energy from the capacitive energy storage device (14) and electrical energy from an energy supply connection (15) of the measuring apparatus (15), the measurement current being driven with a greater electrical power than is consumed by the measuring apparatus (10) via the energy supply connection (15) during the period.

6. Measuring apparatus according to any one of the preceding claims, the high-current generating unit (11) being designed to generate a measurement current of at least 100 A.

7. Measuring apparatus according to any one of the preceding claims, the measurement signal comprising a voltage across the switching contact (5) of the circuit breaker (1).

8. Measuring apparatus according to any one of the preceding claims, the control unit (13) being designed to output digital control signals via a network for opening or closing the switching contact (5).

9. Method for measuring a resistance of a switching contact (5) of an electrical circuit breaker (1), comprising:
- generating a measurement current for the resistance measurement with a high-current generating unit (11),
- feeding the measurement current into the circuit breaker (1),
- controlling the circuit breaker (1) to open or close the switching contact (5), and
- detecting a measurement signal at the circuit breaker (1) during the opening or closing of the switching contact (5) with a measuring unit (12), and
- determining a time-based resistance course of the switching contact (5) during the opening or closing in dependence on the measurement current and the measurement signal as a sequence of digital resistance values,
wherein the method is performed with a measuring apparatus (10), the measuring apparatus (10) comprising a housing (16) in the form of a unit that can be mounted on the switching contact (5), in which housing (16) at least the high-current generating unit (11) and the measuring unit (12) are accommodated, and the measuring apparatus being supplied with electrical energy via an energy supply connection (15),
**characterized by**
- outputting the sequence of digital resistance values via the energy supply connection (15).

10. Method according to Claim 9, the method being performed with the measuring device according to any one of claims 1-8.

11. Method according to claim 10, wherein the measuring apparatus (10) is disposed in immediate proximity to the circuit breaker (1).

12. Method according to claim 10 or claim 11, wherein the measuring apparatus (10) is disposed in immediate proximity to a housing (4) of the switching contact (5).

## Revendications

1. Dispositif de mesure pour mesurer une résistance d'un contact de commutation (5) d'un disjoncteur électrique (1), comprenant :
- une unité de génération de courant fort (11), laquelle est conçue pour la génération d'un courant de mesure pour la mesure de résistance, et laquelle peut être couplée au disjoncteur (1) pour l'amenée du courant de mesure dans le disjoncteur (1), et
- une unité de mesure (12), laquelle peut être couplée au disjoncteur (1), et laquelle est conçue pour détecter un signal de mesure au niveau du disjoncteur (1) pendant l'ouverture ou la fermeture du contact de commutation (5) et pour déterminer une courbe de résistance temporelle du contact de commutation (5) à l'ouverture ou la fermeture en fonction du courant de mesure et du signal de mesure, dans lequel le dispositif de mesure (10) comprend un boîtier (16) sous la forme d'une unité pouvant être montée sur le contact de commutation (5), à l'intérieur duquel boîtier sont logées au moins l'unité de génération de courant fort (11) et l'unité de mesure (12), dans lequel l'unité de mesure (12) est en outre conçue pour déterminer la courbe de résistance du contact de commutation (5) en tant qu'une suite de valeurs de résistance numériques, **caractérisé par** un raccordement d'alimentation en énergie (15) pour l'alimentation en énergie électrique du dispositif de mesure (10), dans lequel l'unité de mesure (12) est conçue pour émettre la suite de valeurs de résistance numériques par l'intermédiaire du raccordement d'alimentation en énergie (15).

2. Dispositif de mesure selon la revendication 1, comprenant par ailleurs une unité de commande (13) dans un boîtier distinct, laquelle est conçue pour commander le disjoncteur (1) pour l'ouverture ou la fermeture du contact de commutation (5).

3. Dispositif de mesure selon la revendication 1 ou 2, dans lequel l'alimentation du dispositif de mesure (10) et la transmission de la suite de valeurs de résistance numériques par le dispositif de mesure (10) s'effectuent par l'intermédiaire des mêmes conducteurs électriques.

4. Dispositif de mesure selon la revendication 3, dans lequel le raccordement d'alimentation en énergie (15) comprend un raccordement Power over Ethernet ou un raccordement Power Line Communication.

5. Dispositif de mesure selon l'une des revendications précédentes, comprenant par ailleurs un accumulateur d'énergie capacitif (14), lequel est couplé à l'unité de génération de courant fort (11), dans lequel l'unité de génération de courant fort (11) est conçue pour générer, pendant un intervalle de temps déterminé, un courant de mesure commandé par de l'énergie électrique de l'accumulateur d'énergie capacitif (14) et de l'énergie électrique d'un raccordement d'alimentation en énergie (15) du dispositif de mesure (10), dans lequel le courant de mesure est commandé avec une puissance électrique plus importante que celle qui est absorbée par le dispositif de mesure (10), pendant l'intervalle de temps, par l'intermédiaire du raccordement d'alimentation en énergie (15).

6. Dispositif de mesure selon l'une des revendications précédentes, dans lequel l'unité de génération de courant fort (11) est conçue pour la génération d'un courant de mesure d'au moins 100A.

7. Dispositif de mesure selon l'une des revendications précédentes, dans lequel le signal de mesure comprend une tension sur le contact de commutation (5) du disjoncteur (1).

8. Dispositif de mesure selon l'une des revendications précédentes, dans lequel l'unité de commande (13) est conçue pour émettre des signaux de commande numériques par l'intermédiaire d'un réseau pour l'ouverture ou la fermeture du contact de commutation (5).

9. Procédé pour mesurer une résistance d'un contact de commutation (5) d'un disjoncteur électrique (1), comprenant :
- la génération d'un courant de mesure pour la mesure de résistance avec une unité de génération de courant fort (11),
- l'amenée du courant de mesure dans le disjoncteur (1),
- la commande du disjoncteur (1) pour l'ouverture ou la fermeture du contact de commutation (5), et
- la détection d'un signal de mesure au niveau du disjoncteur (1) pendant l'ouverture ou la fermeture du contact de commutation (5) avec une unité de mesure (12), et
- la détermination d'une courbe de résistance temporelle du contact de commutation (5) lors de l'ouverture ou la fermeture en fonction du courant de mesure et du signal de mesure en tant qu'une suite de valeurs de résistance numériques,
dans lequel le procédé est exécuté avec un dispositif de mesure, dans lequel le dispositif de mesure (10) comprend un boîtier (16) sous la forme d'une unité pouvant être montée sur le contact de commutation (5), à l'intérieur duquel boîtier sont logées au moins l'unité de génération de courant fort (11) et l'unité de mesure (12), et dans lequel le dispositif de mesure est alimenté en énergie électrique par l'intermédiaire d'un raccordement d'alimentation en énergie (15),
**caractérisé par**
- l'émission de la suite de valeurs de résistance numériques par l'intermédiaire du raccordement d'alimentation en énergie (15).

10. Procédé selon la revendication 9, dans lequel le procédé est exécuté avec le dispositif de mesure (10) selon l'une des revendications 1 à 8.

11. Procédé selon la revendication 10, dans lequel le dispositif de mesure (10) est disposé à proximité immédiate du disjoncteur (1).

12. Procédé selon la revendication 10 ou 11, dans lequel le dispositif de mesure (10) est disposé à proximité immédiate d'un boîtier (4) du contact de commutation (5).
